# EUROPEAN PATENT APPLICATION

(11) **EP 2 339 644 A2**
(43) Date of publication of application: **29.06.2011**
(21) Application number: 10194628.3
(22) Date of filing: 10.12.2010
(51) Int. Cl.: H01L 31/0352, H01L 31/18

(54) **Photovoltaic cell**

(30) Priority: 23.12.2009 US 645660
(71) Applicant: General Electric Company, Schenectady, NY 12345 (US)
(72) Inventor: Korevaar, Bastiaan Arie, Niskayuna, NY 12309 (US); Tsakalakos, Loucas, Niskayuna, NY 12309 (US); Ahmad, Faisal Razi, Niskayuna, NY 12309 (US); Jain, Himanshu, Niskayuna, NY 12309 (US)
(74) Representative: Bedford, Grant Richard

(57) **Abstract**

A photovoltaic (PV) cell (200) is disclosed. The PV cell comprises a plurality of ultrafine structures (202) embedded within a photo-active absorber layer (204) comprising a n-type compound semiconductor.

## Description

The invention relates generally to the area of photovoltaic (PV) cells. More specifically, the invention relates to the area of PV cells wherein the photo-active absorber material employed is a compound semiconductor such as cadmium telluride (CdTe).

The solar spectrum "sunlight" contains a distribution of intensity as a function of frequency. It can be shown that the conversion efficiency for utilizing sunlight to obtain electricity via semiconductors is optimized for semiconducting band-gaps in the range vicinity of about 1.4-1.5 electron volt (eV). The semiconducting band-gap of CdTe, is a good match for this requirement. Quite generally, in the interest of brevity of the discussions herein, PV cells including CdTe as the photo-active material may be referred to as "CdTe PV cells."

Commercial feasibility of large-scale CdTe PV installations has been demonstrated, and the cost of electricity obtained from such large-scale CdTe PV installations is approaching grid parity. Commercial feasibility of smaller scale, that is, area confined, installations remains a challenge within the art due to the relatively poor overall efficiency of such smaller scale installations. Despite significant academic and industrial research and development effort, the best conversion efficiencies for CdTe PV cells have been stagnant for close to a decade, at about 16.5%, even as the entitlement-efficiency of CdTe PV cells for the solar energy spectrum is about 23%. These conversion efficiency numbers may be compared to the overall efficiency of typical currently available commercial large-scale CdTe PV installations including such CdTe PV cells, which conversion efficiency is lower at about 10-11 %.

Improvement in the CdTe PV efficiency will likely result in an improvement in overall efficiency of CdTe PV installations. Such improvement will likely enhance the competitiveness of CdTe PV installations compared to traditional methods of generating electricity such as from natural gas, or coal. It is evident that improvement in overall efficiency will likely enable CdTe PV technology to successfully penetrate markets where small-scale area confined installations are required, such as markets for domestic PV installations.

A CdTe PV cell that is capable of conversion efficiencies greater than about 16% would therefore be highly desirable.

Various embodiments of the invention are directed to a photovoltaic cell.

A photovoltaic (PV) cell comprising, a plurality of ultrafine structures embedded within a photo-active absorber layer comprising n-type cadmium telluride (CdTe).

A photovoltaic (PV) cell comprising, a plurality of ultrafine structures embedded within a photo-active absorber layer comprising a n-type compound semiconductor.

An electricity generating system comprising, a plurality of ultrafine structures comprising a semiconductor having a doping of a first type embedded within a photo-active absorber layer comprising CdTe having a doping of a second type.

A solar cell, comprising, an optical-window-electrode (OWE) layer, a plurality of ultrafine structures comprising a p-type semiconductor embedded within and substantially along a thickness direction of a photo-active absorber layer comprising n-type cadmium telluride (CdTe), and an electrode layer comprising a metal.

A photovoltaic (PV) cell comprising, an optical-window-electrode (OWE) layer, a plurality of ultrafine structures comprising a p-type semiconductor embedded within and substantially along a thickness direction of a photo-active absorber layer comprising n-type cadmium telluride (CdTe), an electrode layer comprising a metal in electrical contact with at least a portion of the plurality of ultrafine structures, and a dielectric layer mediate the photo-active absorber layer and the electrode layer.

A PV system comprising, at least one PV module comprising, a PV cell comprising a plurality of ultrafine structures embedded within a photo-active absorber layer comprising a n-type compound semiconductor, and a radiation concentrator disposed to concentrate electromagnetic radiation at the PV cell.

Various advantages and features will be more readily understood from the following detailed description of preferred embodiments of the invention that is provided in connection with the accompanying drawings, in which:
FIG. 1 is a diagrammatic illustration of a portion of a PV cell including a p-type CdTe layer.
FIG. 2 is a diagrammatic illustration of a PV cell, in accordance with one embodiment of the invention.
FIG. 3 is a diagrammatic illustration of a plurality of metallic ultrafine structures having a conformal coating of a p-type semiconductor, in accordance with one embodiment of the invention.
FIG. 4 is a diagrammatic illustration, substantially of a portion of the PV cell shown in FIG. 2, in accordance with one embodiment of the invention.
FIG. 5 is a diagrammatic illustration of a PV module, in accordance with one embodiment of the invention.
FIG. 6 is a diagrammatic illustration of a PV system, in accordance with one embodiment of the invention.
FIG. 7 is a diagrammatic illustration of a power grid, in accordance with one embodiment of the invention.

In the following description, whenever a particular aspect or feature of an embodiment of the invention is said to comprise or consist of at least one element of a group and combinations thereof, it is understood that the aspect or feature may comprise or consist of any of the elements of the group, either individually or in combination with any of the other elements of that group.

As discussed in detail below, embodiments of the invention are directed to improved photovoltaic (PV) cell designs. Particular embodiments of the invention proposed here provide for a PV cell including a photo-active absorber layer including n-type CdTe, and having an efficiency that is enhanced over the efficiencies of presently available CdTe PV cells (about 16.5%). Embodiments of the CdTe PV cell disclosed herein may display an efficiency in excess of 20%. The photo-active absorber layer disclosed herein is the part of the PV cell where the conversion of electromagnetic energy of incident light, for instance, sunlight, to electrical energy occurs.

However, as discussed in more detail below, quite generally, it is envisaged that the designs and concepts proposed herein may be useful for the development of PV cells including a photo-active absorber layer that includes compound semiconductors other than CdTe. Non-limiting examples of compound semiconductors include indium gallium arsenide, gallium arsenide, indium phosphide, copper indium sulfide, and copper indium gallium selenide, and combinations thereof.

In the discussions herein, the term "ultrafine structures" will be understood to include structures such as nanowires, nanotubes, quantum wires, quantum dots, nanowalls, and combinations thereof of such structures, as also any other structure capable of displaying physical properties similar to one or more physical properties of the aforementioned structures. Quite generally, the term "ultrafine structures" will be understood to include any structure wherein a smallest physical dimension of, or feature of, the structure has a spatial extent "aᵤₛ" of less than about 1 micrometer. It may be appreciated that, for instance, a "mesh," for instance, of nanowires, wherein the mesh extends over a spatial extent in excess of aᵤₛ, but wherein at least a portion of the nanowires have at least one physical dimension that is substantially less than aᵤₛ, is a specific non-limiting example of an ultrafine structure according to the present definition. Further, it will be understood that, for instance, ultrafine structures, wherein a spatial extent, of at least some of the features, such as pores or voids, characterizing the ultrafine structures, is less than about 1 micrometer, fall within the purview of the present invention. In particular embodiments of the invention disclosed herein, the ultrafine structures may be disposed on a substrate, for instance, a thin-film, of the same material from which the ultrafine structures are formed. In more particular embodiments of the invention disclosed herein, the substrate may be formed from a dielectric material, which substrate may also serve as a template for the growth of the ultrafine structures.

Quite generally, in the interest of brevity of the discussions herein, PV cells including CdTe as the photo-active material may be referred to as "CdTe PV cells." The type of doping (p-type or n-type) of the CdTe will be specified, although is non-limiting.

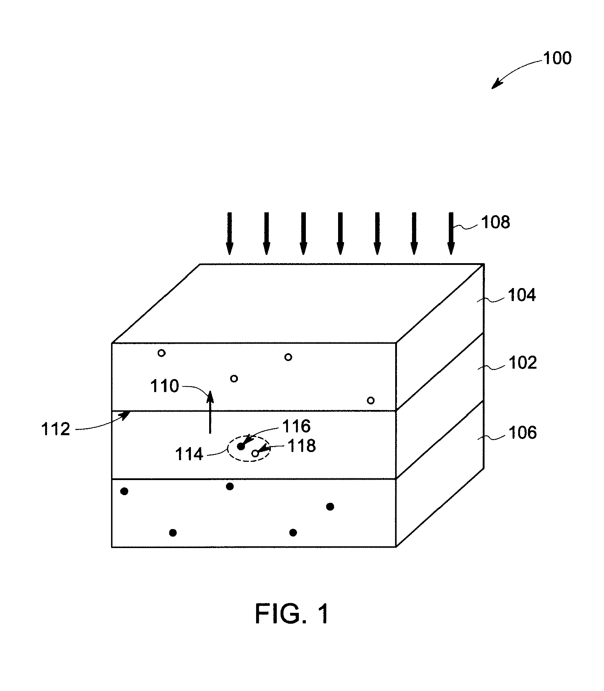

p-type CdTe is currently the most commonly used material in PV cells where the photo-active material is CdTe. Present generation CdTe PV cells utilize p-type CdTe to form an absorber layer. The absorber layer is the part of the PV cell where the conversion of electromagnetic energy of incident light (for instance, sunlight) to electrical energy (that is, to electrical current), occurs. PV cells employing p-type CdTe for forming the absorber layer, however, suffer from multiple issues that have hampered the development of high performance PV cells with efficiencies approaching the entitlement-efficiency of CdTe PV cells for the solar energy spectrum. FIG. 1 is a diagrammatic illustration of a portion 100 of a CdTe PV cell design, for the purposes of discussion of some general operational principles of PV cells. The portion 100 shown includes three layers, 102, 104, and 106. The PV cell portion 100 includes a p-type CdTe layer 102 that is disposed mediate to an n-type optical window layer 104 and an electrode layer 106. The interface between the p-type CdTe layer 102 and the n-type optical window layer 104 may properly be considered as a hetero-junction 112. An electric field 110 is generated across the hetero-junction 112 between the p-type CdTe layer 102 and the n-type optical window layer 104, according to principles that would be known to one of skill in the art of photovoltaics. Light energy flux 108, when it is allowed to be incident on the optical window layer 104, continues on to the CdTe layer 102, wherein the light energy is absorbed to generate electron-hole pairs, that is, the light energy is absorbed to generate electricity. An instance of an electron-hole pair is indicated via reference numeral 114, the hole 118 of the electron-hole pair 114 drifts, under the action of the electric field 110, towards the electrode layer 106 for collection. Similarly, the electron 116 of the electron-hole pair 114 drifts, under the action of electric field 110, towards the n-type optical window layer 104 for collection. In effect therefore, the electrode layer 106 serves as the positive electrode to an external electrical load (not shown in FIG. 1) that is connected to the PV cell (of which portion 100 is a part),

while the n-type optical window layer 104 serves also as a negative electrode to the external electrical load that is connected to the PV cell.

As noted earlier, commonly, CdTe PV cells employ p-type CdTe for forming the absorber layer. An issue of significance in this context, is that, despite several years of research and development work by the industry and academia, it has not been possible to enhance p-type doping levels within the p-type CdTe absorber layer beyond about ∼2 x 10¹⁴ per cubic centimeter (cm). This is among the factors limiting the best reported values of open circuit voltage V_{OC}, and short circuit current density J_{SC}, for present generation CdTe PV cells to about 0.85 Volts, and 0.025 Amperes/cm², respectively. These limitations in turn have limited the best reported efficiencies for present generation CdTe PV cells to about 16.5%.

The insight for the present invention stems from the recognition, by the inventors, that the inability to p-type dope CdTe to higher (beyond about ∼ 2 x 10¹⁴ /cm³) levels is one of the crucial factors hampering the development of CdTe PV cells including a CdTe absorber layer with efficiencies close to the entitlement-efficiency for the solar energy spectrum.

Several reasons have resulted in limiting the p-type doping levels within CdTe to about ∼2 x 10¹⁴ /cm³. One of the reasons is the self-compensating nature of CdTe, which self-compensating nature renders CdTe more amenable to n-type doping, as compared to p-type doping.

It is known that it is possible to achieve higher levels of n-type doping within CdTe, as compared to the levels of p-type doping that can be achieved within CdTe. As discussed above, PV cells (for instance, of type 100) include a p-type CdTe layer as the absorber layer, and require an optical window layer to be disposed on the p-type CdTe layer, so that the interface between the optical window layer and the p-type CdTe layer forms a hetero-junction. On the other hand, there exists a deficiency of materials that can simultaneously form a hetero-junction with n-type CdTe, as well as have optical characteristics that allow them to function suitably as an optical window layer. Thus a deficiency of suitable materials to serve as an optical window layer, when an absorber layer is fabricated from n-type CdTe, has precluded the development of high performance PV cells including an n-type CdTe absorber layer. Characteristics required of the optical window layer include an appropriately high band-gap in order that a sufficient portion of incident light energy may reach the absorber layer. That is, the optical window layer should have an appropriately high optical transmission. Other characteristics required of the optical window layer include a suitably low sheet resistance, in order to diminish series resistance losses within the optical window layer.

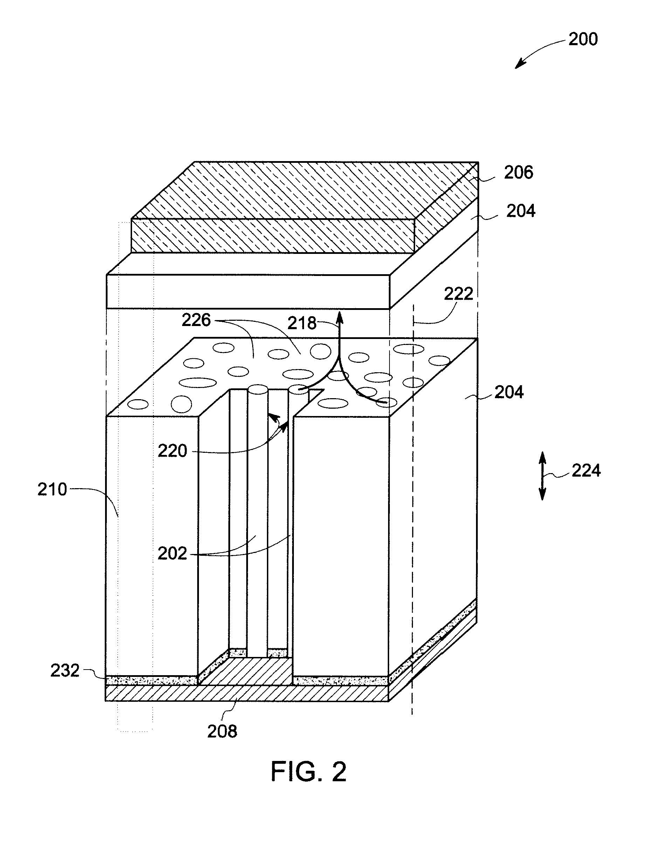

As discussed in detail below in relation to FIGS. 2-4, embodiments of the invention disclosed herein provide approaches that have the potential to enable development of a viable PV cell design including a photo-active absorber n-type CdTe layer. PV cell designs according to embodiments of the present invention circumvent the problem of deficiency of suitable materials for forming an optical window layer when the absorber layer includes n-type CdTe. Embodiments of the present invention therefore may enable the development of a PV cell including a photo-active absorber n-type CdTe layer with an efficiency that is enhanced over the efficiency of present generation CdTe PV cells that include p-type CdTe to form the absorber layer. Particular embodiments of the CdTe PV cells proposed herein may also possess an efficiency that approaches the entitlement-efficiency of CdTe PV cells for the solar energy spectrum. In other words, embodiments of the invention disclosed herein have the potential to enable development of PV cells including a photo-active absorber n-type CdTe layer with efficiencies approaching, and possibly, in excess of, about 20%.

FIG. 2 is a diagrammatic illustration of a PV cell 200 in accordance with one embodiment of the invention, shown in "exploded" view for the sake of clarity. The PV cell 200 includes a plurality of ultrafine structures 202 coupled electrically and mechanically to a substrate 208, which plurality of ultrafine structures 202 are embedded within a photo-active absorber layer 204 comprising n-type CdTe. The plurality of ultrafine structures 202 are in electrical and mechanical contact with the photo-active absorber layer 204. Non-limiting examples of the physical form of the ultrafine structures include single crystalline, polycrystalline, amorphous, and combinations thereof. In particular non-limiting embodiments of the invention, at least a portion of the plurality of ultrafine structures are aligned so that their long axes independently lie substantially along a thickness direction of the photo-active absorber layer. For instance, in the PV cell embodiment 200, the plurality of ultrafine structures 202 are aligned so that their longitudinal axes 222 independently lie substantially along a thickness direction 224 of the photo-active absorber layer 204. The substrate 208 may be any metallic, dielectric, or semiconducting template that is suitable for the growth of ultrafine structures 202, and also possesses appropriate electrical and/or optical characteristics to serve as an electrode and/or as an optical window layer. Furthermore, a dielectric layer 232 may be disposed mediate the photo-active absorber layer 204 and the substrate 208. In particular embodiments of the invention, the dielectric layer 232 serves as a passivation layer. As may be evident from the embodiment illustrated in FIG. 2, the plurality of ultrafine structures 202 penetrate the dielectric layer 232 to make electrical and mechanical contact with the photo-active absorber layer 204. It is clarified, however, that even as the embodiment shown in FIG. 2 includes a dielectric layer 232, PV cells, otherwise similar to PV cell 200, but which do not include a dielectric layer of type 232 fall within the purview of the present invention. In such embodiments of the invention, which do not include a dielectric layer of type 232, the photo-active absorber layer 204 would be in direct electrical and mechanical contact with the substrate 208, and the composition and doping type of which substrate 208 would be substantially similar to the composition and doping type of the plurality of ultrafine structures 202.

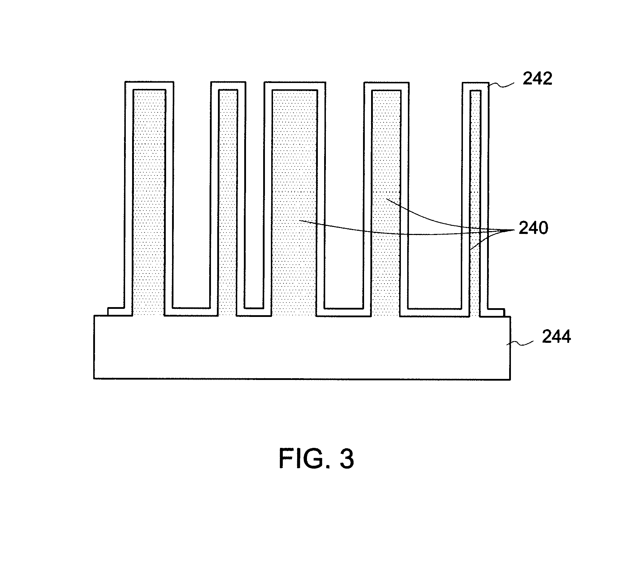

CdTe PV cells wherein the plurality of ultrafine structures 202 include at least one p-type semiconductor material, fall within the purview of the present invention. Quite generally therefore, PV cell embodiments including a plurality of ultrafine structures including a p-type semiconductor fall within the purview of the present invention. Other specific non-limiting embodiments of the invention include a plurality of ultrafine structures that include a plurality of metallic ultrafine structures conformally coated with a p-type semiconductor. For instance, FIG. 3 is a diagrammatic illustration of a plurality of metallic ultrafine structures 240 (of type 202), disposed on a substrate 244 (of type 208), and having a conformal coating comprising a p-type semiconductor 242. Quite generally therefore, PV cell embodiments including a plurality of ultrafine structures including a plurality of metallic ultrafine structures wherein at least a portion of the plurality of metallic ultrafine structures have a conformal coating comprising a p-type semiconductor fall within the purview of the present invention. It is clarified that, even though in FIG. 2, the plurality of ultrafine structures 202 disposed substantially throughout the photo-active absorber layer 204, PV cell embodiments of wherein the plurality of ultrafine structures 204 are disposed only within certain regions of the photo-active absorber layer 204, fall within the purview of the present invention. Furthermore, PV cells wherein the plurality of ultrafine structures 202 are disposed non-homogenously within the photo-active layer 204 fall within the purview of the present invention.

The layer 204 that comprises n-type CdTe, is photo-active and serves as an absorber layer of the PV cell 200. The PV cell 200, further includes a first optical-window-electrode "OWE" layer 206, disposed adjacent the photo-active absorber layer 204. As discussed above, the plurality of ultrafine structures 202 comprise at least one p-type semiconductor material, and therefore an electric field 218 is generated across the p-n junction 220 between the photo-active absorber layer 204 (which photo-active absorber layer 204 includes n-type CdTe) and the plurality of ultrafine structures 202, according to principles that would be known to one of skill in the art of photovoltaics. In the embodiment presently under discussion, the electric field 218 would be directed substantially "outwards" of the individual ultrafine structures of the plurality of ultrafine structures 202, towards bulk portions 226 of the photo-active absorber layer 204, and hence generally also towards the first OWE layer 206. In one embodiment of the invention, the thickness of the photo-active absorber layer 204 can be up to about 10 micrometer. In another embodiment of the invention, the thickness of the photo-active absorber layer 204 can be up to about 5 micrometer. In yet another embodiment of the invention, the thickness of the photo-active absorber layer 204 can be up to about 2 micrometer. In one embodiment of the invention, the photo-active absorber layer 204 is polycrystalline.

In one embodiment of the invention, the PV cell 200 may be configured as a bifacial PV cell. Non-limiting approaches of configuring the PV cell 200 as a bifacial PV cell include fabricating the substrate 208 from materials having suitable optical properties, so that the substrate 208 may function as an OWE layer with functionality similar to the first OWE layer 206. Quite generally, a substrate 208, so fabricated to serve as an OWE layer may be referred to as a "second" OWE layer. A first non-limiting approach, therefore, to configure the substrate 208 as an OWE layer includes forming the substrate 208 to include a p-type transparent conducting oxide. A second non-limiting approach to configure the substrate 208 as an OWE layer includes forming the substrate 208 to include a highly doped p-type semiconductor material, which semiconductor material has a band-gap substantially larger than the band-gap of the material from which the photo-active absorber layer 204 is comprised, and a carrier density that is substantially greater than a carrier density within the ultrafine structures 202. This approach may require an additional layer to be disposed mediate the substrate 208 and the dielectric layer 232. The additional layer (not shown in FIG. 2) may be formed to include, depending on the carrier density of the highly doped p-type semiconductor material, either a p-type transparent conducting oxide (TCO) with a suitable carrier density, or an n-type TCO with a suitable carrier density.

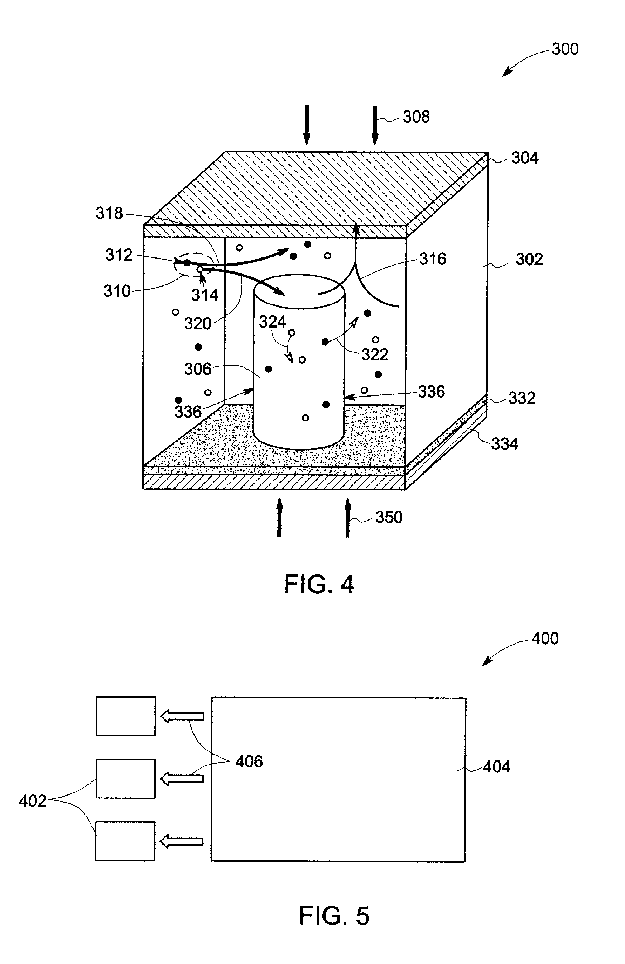

FIG. 4 is a diagrammatic illustration 300 of a portion 210 of the PV cell 200 shown in FIG. 2, for the purposes of discussion of principles of operation of the PV cell 200. Reference numerals 302, and 304 indicate respectively portions of the photo-active absorber layer 204, and of the first OWE layer 206, while reference numeral 306 indicates a single ultrafine structure of the plurality of ultrafine structures 202. As per the discussions earlier in context of FIG. 3, the single ultrafine structure 306 may include a p-type semiconductor, or it may include a metallic ultrafine structure conformally coated with a p-type semiconductor. A portion 336 of the p-n junction 220 between the ultrafine structure 306 and the portion 302 of the photo-active absorber layer 204 is also indicated. A portion of the electric field 218 is indicated via reference numeral 316, which electric field portion 316, according to principles that would be known to one of skill in the art of photovoltaics, directed substantially "outwards" from the single ultrafine structure 306 towards a bulk portion 302 of the photo-active absorber layer 204. In other words, electric field portion 316 points substantially "outwards" from the single ultrafine structure 306 and towards a bulk portion 302 of the photo-active absorber layer 204.

At least a portion of light energy flux 308 incident on the OWE layer 304 (206) continues on to the photo-active absorber layer 302 (204) where it causes the generation of electron-hole pairs. Bifacial embodiments of the PV cell, wherein a light energy flux 350 is allowed to be incident on the substrate 334 (208) (which substrate 334 has been configured to function as an OWE layer), and also cause generation of electron-hole pairs within the photo-active absorber layer 302 (204), fall within the purview of the present invention. The specific attributes required of the substrate 208 to realize such "bifacial" embodiments of the PV cell have been discussed earlier.

As per above, photo-generated electrons and holes are produced within the photo-active absorber layer 302 (204). An instance of a photo-generated electron-hole pair is indicated via reference numeral 310, the hole 314 of which electron-hole pair 310 drifts, under the action of the electric field 316, towards the single ultrafine structure 306 for collection. Similarly, the electron 312 of the electron-hole pair 310 drifts, under the action of electric field 316, towards the first OWE layer 304 (206) for collection. (The direction of drift of the electron 312 and the hole 314 are indicated via reference numerals 318 and 320 respectively. Quite generally, the general direction of drift of holes towards the ultrafine structures 306 (202), and of the electrons towards the first OWE layer are indicated by reference numerals 322 and 324 respectively.) A portion 332 of the dielectric layer 232 that lies mediate the portion 334 of the substrate 208 and the portion 302 of the photo-active absorber layer 204 is indicated. Those of skill in the art, based on the discussions herein, may now appreciate that, in effect, the ultrafine structure 306 (and quite generally, the plurality of ultrafine structures 202) since it collects holes, serves as a positive electrode for an external electrical load (not shown) connected to the PV cell 200. Those of skill in the art may now also recognize that, quite generally, the plurality of ultrafine structures 202 collect the portion of a photo-current that is due to the photo-generated electron-hole pairs generated within the photo-active absorber layer 302 (204). (The photo-current is the sum total of the current due to the photo-generated electrons and holes, for instance, of type 312 and 314 respectively.) It may be appreciated that, quite generally, PV cell embodiments wherein an output current generated by the PV cell includes photo-current generated within the plurality of ultrafine structures 202 and photo-current generated within the photo-active absorber layer 204. Those of skill in the art would further appreciate that the first OWE layer 304 (206) since it collects electrons, serves also as a negative electrode for the external electrical load (not shown) connected to the PV cell 200.

As discussed at least in context of the embodiments of the invention depicted in FIGS. 2, 3, and 4, the plurality of ultrafine structures 202 are embedded within the photo-active absorber layer 204. It is noted that the photo-current generation within embodiments of the present invention takes place substantially within the photo-active absorber layer, while the plurality of ultrafme structures 202 serve to extract at least a portion of the photo-current. (However, the inventors recognize that photo-current generation likely occurs also within the plurality of ultrafine structures 202. However, it is likely that a substantially significant portion of the photo-current generation occurs within the photo-active absorber layer 204.) It is envisaged that the typical spacing between individual ultrafine structures of the plurality of ultrafine structures 202, may advantageously be at least of the order of twice the depletion length scale of the p-n junction 220. Such spacing would likely result in a diminution in overlap of electric fields within the depletion regions surrounding and corresponding to the individual ultrafine structures.

It is noted that, within embodiments of the invention disclosed herein, the layer 204 serves as a photo-active absorber layer wherein occurs a substantial portion of the photo-current generation, and within which layer 204 are embedded the plurality of ultrafine structures 202. It is similarly noted that, within embodiments of the invention disclosed herein, the plurality of ultrafine structures 202 serve to collect the photo-generated holes generated substantially within the layer 204.

The open circuit voltage "V_{OC}" and the short circuit current density "J_{SC}" are among the standard figures of merit on the basis of which performance of PV cells may be evaluated. Embodiments of the invention include PV cells (for instance, of type 200) including a photo-active absorber layer (for instance, of type 204), which PV cells are potentially capable of generating an open circuit voltage "V_{OC}" of up to about 1.05 Volt. More particular embodiments of the invention include PV cells (for instance, of type 200) including a photo-active absorber layer (for instance, of type 204), which PV cells are potentially capable of generating a short circuit current density "J_{SC}" of up to about 0.03 Ampere/cm². Due to such range of achievable values of V_{OC} and J_{SC,} it is envisaged that PV cells according to embodiments of the present invention, may be capable of achieving conversion efficiencies (for conversion of light energy to electrical energy) substantially in excess of about 16.5%. Due to such range of achievable values of V_{OC} and J_{SC}, it is further envisaged that more particular PV cell embodiments according to the present invention, may be capable of achieving conversion efficiencies in excess of about 20%.

In one embodiment of the invention, the plurality of ultrafine structures 202 comprise a material having a semiconducting band-gap substantially greater than the semiconducting band-gap of the n-type CdTe from which is comprised the photo-active absorber layer 204. In one embodiment of the invention, the plurality of ultrafine structures 202 comprise a material having a semiconducting band-gap substantially equal to the semiconducting band-gap of the n-type CdTe from which is comprised the photo-active absorber layer 204. Furthermore, as noted earlier, the plurality of ultrafine structures 202 include at least one p-type semiconductor. In one embodiment of the invention, a carrier density within the photo-active absorber layer 204 lies within a range from about 10¹⁵ /cm³ to about 10¹⁷ /cm³. In one embodiment of the invention, a carrier density within the plurality of ultrafine structures 202 lies within a range from about 10¹⁷ /cm³ to about 10²⁰ /cm³.

In one embodiment of the invention, the first OWE layer 206 includes a transparent conducting oxide. In more particular embodiments of the invention, the first OWE layer 206 may include one or more n-type dopants. Non-limiting examples of transparent conducting oxides include, indium tin oxide (ITO), indium zinc oxide (IZO), aluminum zinc oxide (AZO), amorphous zinc oxide (aZO), cadmium stannate (Cd₂SnO₄), zinc oxide (ZnO), tin oxide (SnO₂) indium oxide (In₂O₃), cadmium tin oxide, fluorinated tin oxide, and combinations thereof. More particular embodiments of the invention include a first OWE layer including a n-type semiconductor. Non-limiting examples of n-type semiconductors include, cadmium sulfide (CdS), zinc telluride (ZnTe), zinc selenide (ZnSe), cadmium selenide (CdSe), zinc sulfide (ZnS), indium selenide (In₂Se₃), or indium sulfide (In₂S₃), and combinations thereof.

In one embodiment of the invention, the plurality of ultrafine structures 202 comprise germanium, silicon, cadmium telluride, gallium arsenide, indium gallium arsenide, mercury cadmium telluride, or zinc telluride. In one embodiment of the invention, at least a portion of the plurality of ultrafine structures 202 comprise a structure comprising at least one nanowire, or at least one nanotube, or at least one quantum wire, or at least one quantum dot, or at least one nanowall. In particular, individual ultrafine structures of the plurality of ultrafine structures 202 may be formed as a "pillar," or "string" of quantum dots. In one embodiment of the invention, at least one physical dimension of at least a portion of the plurality of ultrafine structures is less than about 1 micrometer. In more particular embodiments of the invention, at least one physical dimension of at least a portion of the plurality of ultrafine structures is less than about 500 nanometers. In more particular embodiments of the invention, at least one physical dimension of at least a portion of the plurality of ultrafine structures is less than about 200 nanometers. In more particular embodiments of the invention, at least one physical dimension of at least a portion of the plurality of ultrafine structures is less than about 100 nanometers.

In view of the discussions herein, it may be appreciated that, quite generally, embodiments of the invention include an electricity generating system (for instance, a PV cell of type 200) that includes a plurality of semiconductor ultrafine structures (for instance, of type 202) having a doping of a first type embedded within a photo-active absorber layer comprising CdTe (for instance, of type 204) having a doping of a second type. In one embodiment of the invention, doping of the first type includes p-type doping. In another embodiment of the invention, doping of the second type includes n-type doping. The p-, and n-type doping can be achieved respectively via p-, and n-type dopants according to principles that would be known to one of skill in the art of photovoltaics. Non-limiting examples of p-type dopants include boron, and aluminum. Non-limiting examples of n-type dopants include phosphorous, arsenic, and antimony. It is remarked that p-, and n-type dopants are well known in the art.

In view of the discussions herein, it may be appreciated that, embodiments of the invention include a solar cell (for instance, of type 200), including an OWE layer (for instance, of type 206), a plurality of ultrafine structures comprising a p-type semiconductor (for instance, ultrafine structures of type 202) embedded within and substantially along a thickness direction (for instance, of type 224) of a photo-active absorber layer comprising n-type CdTe (for instance, of type 204), and an electrode layer comprising a metal (for instance, of type 208). In particular embodiments of the invention, the p-type semiconductor comprises p-type CdTe. In more particular embodiments of the invention, a p-n junction (for instance, of type 220) between the plurality of ultrafine structures comprising a p-type semiconductor, and the photo-active absorber layer comprising n-type CdTe, is a homo-junction.

In view of the discussions herein, it may be appreciated that embodiments of the invention include a PV cell (for instance, of type 200) including an OWE layer (for instance, of type 206), a plurality of ultrafine structures including a p-type semiconductor (for instance, of type 202) embedded within and substantially along a thickness direction (for instance, of type 224) of a photo-active absorber layer comprising n-type CdTe (for instance, of type 204), an electrode layer comprising a metal (for instance, of type 208) in electrical contact with at least a portion of the plurality of ultrafme structures, and a dielectric layer (for instance, of type 232) mediate the photo-active absorber layer and the electrode layer.

In view of the discussions herein, it may now be appreciated that, quite generally, embodiments of the invention include a PV cell (similar in structure to the PV cell 200) including a plurality of ultrafine structures (for instance, of type 202) embedded within a photo-active absorber layer comprising a n-type compound semiconductor (similar in structure to the photo-active absorber layer 204). Non-limiting examples of compound semiconductors include indium gallium arsenide, gallium arsenide, indium phosphide, copper indium sulfide, and copper indium gallium selenide. The compound semiconductor can have a physical form selected from the group consisting of single crystalline, polycrystalline, and combinations thereof.

FIG. 5 is a diagrammatic illustration of a PV module 400 in accordance with one embodiment of the invention. The PV module 400 includes at least one PV cell 402 including a plurality of ultrafine structures (for instance, of type 202) embedded within a photo-active absorber layer comprising a n-type compound semiconductor (for instance, of type 204). The PV module 400 also includes a radiation (that is, light energy flux) concentrator 404 disposed to direct a light energy flux 406 to be incident on, for instance, an OWE layer (for instance, of type 206) of the PV cell 402. The principles of operation and construction of radiation concentrators would be known to one of skill in the art. PV modules (for instance, of type 400) including radiation concentrators (for instance, of type 404) capable of concentrating incident radiation by up to about 500 times fall within the purview of the present invention. Particular embodiments of the invention include PV cells wherein the photo-active absorber layer (for instance, of type 204) is substantially single crystalline. Particular embodiments of the invention include PV cells wherein the plurality of ultrafine structures (for instance, of type 202) comprise a p-type semiconductor. More particular embodiments of the PV module include PV cells wherein the compound semiconductor comprises gallium arsenide.

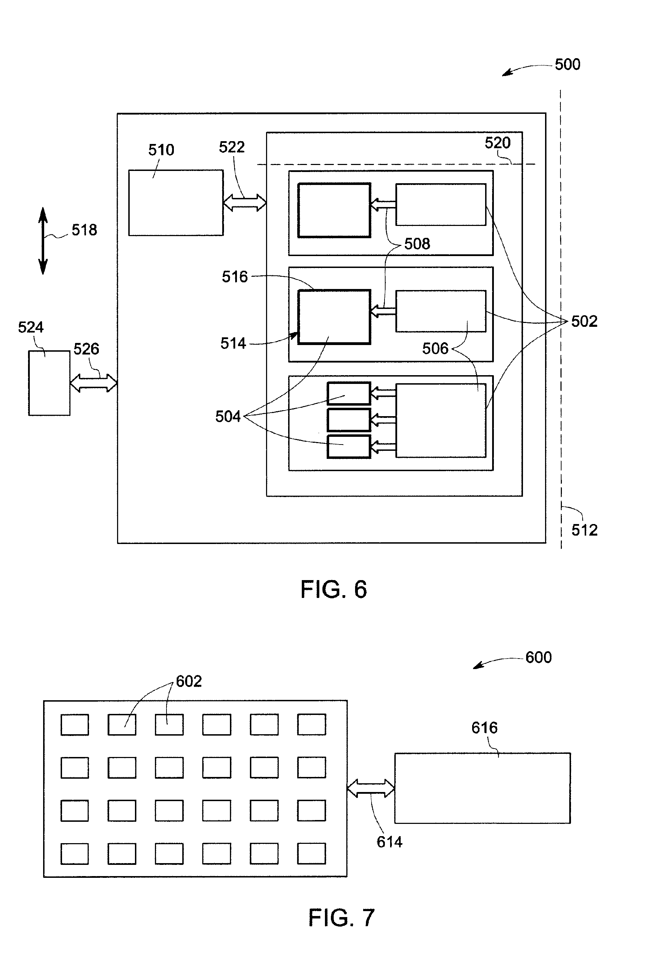

FIG. 6 is a diagrammatic illustration of a PV system 500 in accordance with one embodiment of the invention. The PV system 500 includes at least one PV module 502 (for instance, of type 400). Each of the PV modules 502 includes at least one PV cell 504 including a plurality of ultrafine structures (for instance, of type 202) embedded within a photo-active absorber layer comprising a n-type compound semiconductor (for instance, of type 204). Each of the PV modules 502 also includes a radiation concentrator 506 disposed to direct a light energy flux 508 to be incident on, for instance, an OWE layer (for instance, of type 206) of the corresponding PV cell. The PV system 500 may further include a thermal management system 510 equipped to protect the PV system 500 from undesirable heating, which thermal management system 510 is in thermal communication 522 with the at least one PV module 502. The principles of operation and construction of thermal management systems would be known to one of skill in the art. Embodiments, wherein the thermal management system 510 includes a metal strip 516 disposed along a perimeter of one or more of the PV cells 504 fall within the purview of the present invention.

PV systems (for instance, of type 500) including a tracking system 524 that is at least in electrical and mechanical communication 526 with the PV modules 502 and/or with the thermal management system 510 fall within the purview of the present invention. It is pointed out that, even though in FIG. 5, the tracking system 524 is shown to be in electrical and mechanical communication 526 with the PV modules 502 as well as with the thermal management system 510, more particular embodiments of the invention include tracking systems that are in electrical and mechanical communication with only the PV modules 502, or with only the thermal management system 510. The tracking system 524 is configured to dynamically orient the system to receive light energy flux emitted by a moving light source, such as the sun. PV systems that include a long axis 512 disposed along an east-west direction 518 fall within the purview of the present invention. More particular embodiments of the invention include at least two PV modules (for instance, of type 400). Embodiments wherein the at least two PV modules are arranged in space so that they lie in substantially the same plane with their individual long axes (for instance, of type 520) aligned substantially parallel to each other, fall within the purview of the present invention. Embodiments, wherein each of the at least two PV modules (for instance, of type 400) are arranged in space so that they lie in substantially the same plane with their individual long-axes (for instance, of type 520) aligned substantially parallel to an east-west direction 518, also fall within the purview of the present invention.

FIG. 7 is a diagrammatic illustration of a power grid 600 in accordance with one embodiment of the invention. The power grid 600 includes at least one PV system 602 (for instance, of type 500). Each of the PV systems 602 includes at least one PV module (for instance, of type 400). Each of the PV modules includes at least one PV cell (for instance, of type 200) including a plurality of ultrafine structures (for instance, of type 202) embedded within a photo-active absorber layer comprising a n-type compound semiconductor (for instance, of type 204). Each of the PV modules also includes a radiation concentrator disposed to direct a light energy flux to be incident on, for instance, an OWE layer (for instance, of type 206) of the corresponding PV cell. The principles of operation and construction of radiation concentrators would be known to one of skill in the art. Each of the PV systems 602 also includes a thermal management system equipped to protect the corresponding PV system from undesirable heating. The principles of operation and construction of thermal management systems would be known to one of skill in the art. The power grid 600 also includes a power distribution system 614. The principles of operation and construction of power distribution systems would be known to one of skill in the art. The power distribution system 614 services the electrical power requirements of an end user community 616.

While the invention has been described in detail in connection with only a limited number of embodiments, it should be readily understood that the invention is not limited to such disclosed embodiments. Rather, the invention can be modified to incorporate any number of variations, alterations, substitutions or equivalent arrangements not heretofore described, but which are commensurate with the spirit and scope of the invention. Additionally, while various embodiments of the invention have been described, it is to be understood that aspects of the invention may include only some of the described embodiments. Accordingly, the invention is not to be seen as limited by the foregoing description, but is only limited by the scope of the appended claims.

Various aspects and embodiments of the present invention are defined by the following numbered clauses:
1. A photovoltaic (PV) cell comprising:
   a plurality of ultrafine structures embedded within a photo-active absorber layer comprising n-type cadmium telluride (CdTe).
2. The PV cell of clause 1, further comprising a first optical-window-electrode (OWE) layer.
3. The PV cell of any preceding clause, wherein the first OWE layer comprises an n-type semiconductor.
4. The PV cell of any preceding clause, wherein the n-type semiconductor comprises at least one of cadmium sulfide, zinc telluride, zinc selenide, cadmium selenide, zinc sulfide, indium selenide, or indium sulfide.
5. The PV cell of any preceding clause, wherein the first OWE layer comprises a transparent conducting oxide.
6. The PV cell of any preceding clause, wherein the transparent conducting oxide comprises at least one of indium tin oxide, indium zinc oxide, aluminum zinc oxide, amorphous zinc oxide, cadmium stannate, cadmium tin oxide, fluorinated tin oxide, zinc oxide, tin oxide, or indium oxide.
7. The PV cell of any preceding clause, wherein the plurality of ultrafine structures comprise a p-type semiconductor.
8. The PV cell of any preceding clause, further comprising a second OWE layer comprising a p-type transparent conducting oxide or a p-type semiconductor.
9. The PV cell of any preceding clause, wherein the PV cell is bifacial.
10. The PV cell of any preceding clause, wherein the plurality of ultrafine structures comprise a plurality of metallic ultrafine structures wherein at least a portion of the plurality of metallic ultrafine structures have a conformal coating comprising a p-type semiconductor.
11. The PV cell of any preceding clause, wherein the photo-active absorber layer has a thickness of up to about 10 micrometers.
12. The PV cell of any preceding clause, wherein at least a portion of the plurality of ultrafine structures are aligned so that their longitudinal axes independently lie substantially along a thickness direction of the photo-active absorber layer.
13. The PV cell of any preceding clause, wherein the plurality of ultrafine structures comprise germanium, silicon, cadmium telluride, gallium arsenide, indium gallium arsenide, mercury cadmium telluride, or zinc telluride.
14. The PV cell of any preceding clause, wherein the plurality of ultrafine structures comprise a material having a semiconducting band-gap that is substantially greater than a semiconducting band-gap of the n-type CdTe.
15. The PV cell of any preceding clause, wherein the plurality of ultrafine structures comprise a material having a semiconducting band-gap that is substantially equal to a semiconducting band-gap of the n-type CdTe.
16. The PV cell of any preceding clause, wherein a carrier density within the photo-active absorber layer lies within a range from about 10¹⁵ /cm³ to about 10¹⁷ /cm³.
17. The PV cell of any preceding clause, wherein a carrier density within the plurality of ultrafine structures lies within a range from about 10¹⁷ /cm³ to about 10²⁰ /cm³_{.}
18. The PV cell of any preceding clause, wherein at least one physical dimension of at least a portion of the plurality of ultrafine structures is less than about 1 micrometer.
19. The PV cell of any preceding clause, wherein a spatial extent of a feature characterizing the plurality of ultrafine structures is less than about 1 micrometer.
20. The PV cell of any preceding clause, wherein at least a portion of the plurality of ultrafine structures comprise a structure comprising at least one nanowire, or at least one nanotube, or at least one quantum wire, or at least one quantum dot, or at least one nanowall.
21. The PV cell of any preceding clause, wherein the photo-active absorber layer is polycrystalline.
22. The PV cell of any preceding clause, wherein the ultrafine structures have a physical form selected from the group consisting of single crystalline, polycrystalline, and combinations thereof.
23. A photovoltaic (PV) cell comprising:
   a plurality of ultrafine structures embedded within a photo-active absorber layer comprising a n-type compound semiconductor.
24. The PV cell of any preceding clause, wherein the compound semiconductor comprises indium gallium arsenide, gallium arsenide, indium phosphide, copper indium sulfide, or copper indium gallium selenide.
25. The PV module of any preceding clause, wherein the compound semiconductor has a physical form selected from the group consisting of single crystalline, polycrystalline, and combinations thereof.
26. An electricity generating system comprising:
   a plurality of ultrafine structures comprising a semiconductor having a doping of a first type embedded within a photo-active absorber layer comprising CdTe having a doping of a second type.
27. The electricity generating system of any preceding clause, wherein doping of the first type comprises p-type doping and doping of the second type comprises n-type doping.
28. A solar cell, comprising:
   an optical-window-electrode (OWE) layer;
   a plurality of ultrafine structures comprising a p-type semiconductor embedded within and substantially along a thickness direction of a photo-active absorber layer comprising n-type cadmium telluride (CdTe); and
   an electrode layer comprising a metal.
29. The solar cell of any preceding clause, wherein the p-type semiconductor comprises p-type CdTe.
30. A photovoltaic (PV) cell comprising:
   an optical-window-electrode (OWE) layer;
   a plurality of ultrafine structures comprising a p-type semiconductor embedded within and substantially along a thickness direction of a photo-active absorber layer comprising n-type cadmium telluride (CdTe);
   an electrode layer comprising a metal in electrical contact with at least a portion of the plurality of ultrafme structures; and
   a dielectric layer mediate the photo-active absorber layer and the electrode layer.
31. The PV cell of any preceding clause, wherein the plurality of ultrafme structures penetrate the dielectric layer.
32. A PV system comprising:
   at least one PV module comprising:
      a PV cell comprising a plurality of ultrafine structures embedded within a photo-active absorber layer comprising a n-type compound semiconductor; and a radiation concentrator disposed to concentrate electromagnetic radiation at the PV cell.
33. The PV system of any preceding clause, further comprising a thermal management system in thermal communication with the at least one PV module.
34. The PV module of any preceding clause, wherein the compound semiconductor comprises gallium arsenide.

## Claims

1. A photovoltaic (PV) cell (200) comprising:
a plurality of ultrafine structures (202) embedded within a photo-active absorber layer (204) comprising n-type cadmium telluride (CdTe).

2. The PV cell (200) of claim 1, further comprising a first optical-window-electrode (OWE) layer (206).

3. The PV cell (200) of any preceding claim, wherein the plurality of ultrafine structures comprise a p-type semiconductor.

4. The PV cell (200) of any preceding claim, wherein the plurality of ultrafme structures comprise a plurality of metallic ultrafine structures (240) wherein at least a portion of the plurality of metallic ultrafine structures have a conformal coating comprising a p-type semiconductor (242).

5. The PV cell 200 of any preceding claim, wherein at least a portion of the plurality of ultrafine structures are aligned so that their longitudinal axes (222) independently lie substantially along a thickness direction (224) of the photo-active absorber layer.

6. A photovoltaic (PV) cell (200) comprising:
a plurality of ultrafine structures (202) embedded within a photo-active absorber layer (204) comprising a n-type compound semiconductor.

7. An electricity generating system (200) comprising:
a plurality of ultrafine structures (202) comprising a semiconductor having a doping of a first type embedded within a photo-active absorber layer (204) comprising CdTe having a doping of a second type.

8. A solar cell (200), comprising:
an optical-window-electrode (OWE) layer (206);
a plurality of ultrafine structures (202) comprising a p-type semiconductor embedded within and substantially along a thickness direction (224) of a photo-active absorber layer (204) comprising n-type cadmium telluride (CdTe); and
an electrode layer (208) comprising a metal.

9. A photovoltaic (PV) cell (200) comprising:
an optical-window-electrode (OWE) layer (206);
a plurality of ultrafine structures (202) comprising a p-type semiconductor embedded within and substantially along a thickness direction (224) of a photo-active absorber layer (204) comprising n-type cadmium telluride (CdTe);
an electrode layer (208) comprising a metal in electrical contact with at least a portion of the plurality of ultrafme structures; and
a dielectric layer (232) mediate the photo-active absorber layer and the electrode layer.

10. A PV system (500) comprising:
at least one PV module (400) comprising:
a PV cell (200) comprising a plurality of ultrafme structures (202) embedded within a photo-active absorber layer (204) comprising a n-type compound semiconductor; and
a radiation concentrator (404) disposed to concentrate electromagnetic radiation (406) at the PV cell.
